# EUROPEAN PATENT APPLICATION

(11) **EP 4 745 595 A1**
(43) Date of publication of application: **20.05.2026**
(21) Application number: 25215508.0
(22) Date of filing: 13.11.2025
(51) Int. Cl.: G01R 31/367, G01R 31/3835

(54) **BATTERY DIAGNOSTIC APPARATUS AND A METHOD THEREOF**

(30) Priority: 15.11.2024 KR 20240162763; 10.10.2025 KR 20250146212
(71) Applicant: Hyundai Motor Company, Seoul 06797 (KR); Kia Corporation, Seoul 06797 (KR)
(72) Inventor: BAEK, Ki Seung, 18280 Hwaseong-si, Gyeonggi-do (KR); HWANG, Do Sung, 18280 Hwaseong-si, Gyeonggi-do (KR); HONG, Ki Chul, 18280 Hwaseong-si, Gyeonggi-do (KR)
(74) Representative: Viering, Jentschura & Partner mbB Patent- und Rechtsanwälte

(57) **Abstract**

A battery diagnostic apparatus includes a memory and a processor. The processor determines whether a condition for determining a failure in a battery cell is satisfied, identifies a first voltage of the battery cell at a first time point, a second voltage at a second time point, and a third voltage at a third time point, determines that an abnormal voltage variation is detected in the battery cell, based on an absolute value of a difference between the first voltage and the third voltage being greater than a first threshold and an absolute value of a difference between the second voltage and the third voltage being greater than the first threshold, and determines that the failure occurs in the battery cell, based on an absolute value of a difference between the first voltage and a predetermined reference voltage being greater than a second threshold.

## Description

### CROSS-REFERENCE TO RELATED APPLICATION

This application claims the benefit of and priority to Korean Patent Application No. 10-2024-0162763, filed in the Korean Intellectual Property Office on November 15, 2024, and Korean Patent Application No. 10-2025-0146212, filed in the Korean Intellectual Property Office on October 10, 2025. The entire contents of these two applications are incorporated herein by reference.

### TECHNICAL FIELD

The present disclosure relates to a battery diagnostic apparatus and a method thereof, and more particularly, relates to technologies for diagnosing a failure in a battery cell.

### BACKGROUND

In general, a battery is provided in a vehicle. A plurality of battery cells is connected in series or parallel with each other to configure the battery. Each battery cell is connected with a separate sensing integrated circuit (IC) to measure a cell voltage. The measured voltage value is delivered to a battery management system (BMS) to be used for safety control and operation control of the battery.

Because an abnormal state of the battery is mainly shown as abnormal behavior of a temperature or voltage value of the battery cell, a technology for accurately detecting a change in battery cell voltage and diagnosing whether there is abnormality is known as a very important technology in the safety control of the battery.

However, in an existing technology, if a change in battery cell voltage momentarily occurs, there is a possibility of misunderstanding it as a normal variation or incorrectly determining temporary noise as an abnormal state. Furthermore, because a condition for determining a failure in the battery cell is not sufficiently considered, there is a limitation which is difficult to reflect various situations occurring in an actual operation environment.

### SUMMARY

The present disclosure has been made to solve the above-mentioned problems occurring in the prior art while advantages achieved by the prior art are maintained intact.

An aspect of the present disclosure provides a battery diagnostic apparatus and a method for detecting a momentary voltage variation capable of occurring in a battery cell to quickly diagnose an abnormal state of a cell, which is difficult to be detected using only a determination of whether there is a simple over-voltage or low-voltage.

Another aspect of the present disclosure provides a battery diagnostic apparatus and a method for, when a voltage variation in the battery cell is greater than a specific threshold is not merely determined as a single event and is repeated a certain number of times or more, finalizing or confirming this as a failure, to reduce misdetection due to temporary noise and improve accuracy of the diagnosed result.

Another aspect of the present disclosure provides a battery diagnostic apparatus and a method for including a function of setting a voltage immediately before an abnormal variation in the battery cell voltage is detected as a reference voltage and updating the reference voltage, if a normal state is subsequently checked, to adaptively respond to a change in battery state in an actual driving and charging environment.

Another aspect of the present disclosure provides a battery diagnostic apparatus and a method for, if the failure in the battery cell is finalized or confirmed, generating a diagnostic trouble code (DTC) associated with this or performing subsequent control, such as a restriction on charging, a restriction on output, or generation of an alarm, to quickly notify a vehicle driver of an abnormal situation and ensure vehicle safety and a method thereof.

The technical problems to be solved by the present disclosure are not limited to the aforementioned problems, and any other technical problems not mentioned herein should be clearly understood from the following description by those having ordinary skill in the art to which the present disclosure pertains.

According to an aspect of the present disclosure, a battery diagnostic apparatus may include a memory storing program instructions and a processor that executes the program instructions. By executing the program instructions, the processor may determine whether a condition for determining a failure in a battery cell is satisfied, may determine or identify each of a first voltage of the battery cell at a first time point, a second voltage of the battery cell at a second time point, and a third voltage of the battery cell at a third time point, may determine that a voltage variation failing to satisfy a pre-determined voltage variation condition (hereinafter, also referred to as "an abnormal voltage variation)" is detected in the battery cell, based on an absolute value of a difference between the first voltage and the third voltage being greater than a first threshold and an absolute value of a difference between the second voltage and the third voltage being greater than the first threshold, and may determine that the failure occurs in the battery cell, based on that the abnormal voltage variation is detected and an absolute value of a difference between the first voltage and a predetermined reference voltage is greater than a second threshold. The second time point may be a time point before a predetermined time interval from the first time point. The third time point may be a time point before a time interval which may be predetermined from the second time point.

In an embodiment, the processor may finalize, confirm, or finally confirm the failure in the battery cell, based on that the number of times it is determined that the failure occurs in the battery cell is greater than a predetermined number of times, within a cycle associated with a battery management system of a vehicle including the battery cell.

In an embodiment, the cycle may include a cycle from a time point at which the battery management system becomes an active state to a time point at which the active state switches to an inactive state.

In an embodiment, the processor may not increase or may maintain the number of times it is determined that the failure occurs in the battery cell, if a state in which an absolute value of a difference between a voltage measured a time point subsequent to the first time point and the third voltage is greater than the first threshold continues (or based on a state in which an absolute value of a difference between a voltage measured a time point subsequent to the first time point and the third voltage is greater than the first threshold being maintained).

In an embodiment, the processor may determine the first voltage and the second voltage as voltages failing to satisfy a pre-determined voltage condition (hereinafter, also referred to as "abnormal voltages"), based on determining that the abnormal voltage variation is detected in the battery cell.

In an embodiment, the processor may determine a voltage immediately before the abnormal voltage variation is detected, among voltages measured in a state in which the condition for determining the failure in the battery cell is satisfied, as the reference voltage.

In an embodiment, the processor may update the reference voltage to a fourth voltage measured after it is determined that the failure occurs in the battery cell, if an absolute value of a difference between the fourth voltage and the third voltage is smaller than or equal to the first threshold (or based on an absolute value of a difference between the fourth voltage and the third voltage being smaller than or equal to the first threshold) .

In an embodiment, the condition for determining the failure in the battery cell may include or be associated with at least one of whether a vehicle including the battery cell is parking, whether the battery cell is being charged, a time elapsed after the vehicle is turned off, a temperature of the battery cell, a state of charge (SOC) of the battery cell, a current of the battery cell, or whether a voltage of the battery cell is normally measured (e.g., measured under a pre-determined measurement condition), or any combination thereof.

In an embodiment, the processor may determine whether the abnormal voltage variation is detected in the battery cell, based on a time when the condition for determining the failure in the battery cell is satisfied being greater than or exceeding a predetermined time.

In an embodiment, the processor may perform at least one of a restriction on charging the battery cell, a restriction on an output of the battery cell, generation of an alarm associated with the failure in the battery cell, or any combination thereof, based on determining that the failure occurs in the battery cell.

According to another aspect of the present disclosure, a battery diagnostic method may include: determining, by a processor, whether a condition for determining a failure in a battery cell is satisfied; determining or identifying, by the processor, each of a first voltage of the battery cell at a first time point, a second voltage of the battery cell at a second time point, and a third voltage of the battery cell at a third time point; determining, by the processor, that an abnormal voltage variation is detected in the battery cell, based on an absolute value of a difference between the first voltage and the third voltage being greater than a first threshold and an absolute value of a difference between the second voltage and the third voltage being greater than the first threshold; and determining, by the processor, that the failure occurs in the battery cell, based on that the abnormal voltage variation is detected and an absolute value of a difference between the first voltage and a reference voltage is greater than a second threshold. The second time point may be a time point before a predetermined time interval from the first time point. The third time point may be a time point before a predetermined time interval from the second time point.

The battery diagnostic method according to an embodiment may further include finalizing, confirming, or finally confirming, by the processor, the failure in the battery cell, based on that the number of times it is determined that the failure occurs in the battery cell is greater than a predetermined number of times, within a cycle associated with a battery management system of a vehicle including the battery cell.

In the battery diagnostic method according to an embodiment, the cycle may include a cycle from a time point in which the battery management system becomes an active state to a time point in which the active state switches to an inactive state.

The battery diagnostic method according to an embodiment may further include not increasing (e.g., maintaining) the number of times it is determined that the failure occurs in the battery cell, if a state in which an absolute value of a difference between a voltage measured a time point subsequent to the first time point and the third voltage is greater than the first threshold continues (or based on a state in which an absolute value of a difference between a voltage measured a time point subsequent to the first time point and the third voltage is greater than the first threshold being maintained).

In the battery diagnostic method according to an embodiment, determining, by the processor, that the abnormal voltage variation is detected in the battery cell, based on that the absolute value of the difference between the first voltage and the third voltage is greater than the first threshold and the absolute value of the difference between the second voltage and the third voltage is greater than the first threshold, may include determining, by the processor, the first voltage and the second voltage as abnormal voltages, based on determining that the abnormal voltage variation is detected in the battery cell.

In the battery diagnostic method according to an embodiment, determining, by the processor, that the failure occurs in the battery cell, based on that the abnormal voltage variation is detected and the absolute value of the difference between the first voltage and the reference voltage is greater than the second threshold, may include determining, by the processor, a voltage immediately before the abnormal voltage variation is detected, among voltages measured in a state in which the condition for determining the failure in the battery cell is satisfied, as the reference voltage.

The battery diagnostic method according to an embodiment may further include updating, by the processor, the reference voltage to a fourth voltage measured after it is determined that the failure occurs in the battery cell, if an absolute value of a difference between the fourth voltage and the third voltage is smaller than or equal to the first threshold (or based on an absolute value of a difference between the fourth voltage and the third voltage being smaller than or equal to the first threshold) .

In the battery diagnostic method according to an embodiment, the condition for determining the failure in the battery cell may include or be associated with at least one of whether a vehicle including the battery cell is parking, whether the battery cell is being charged, a time elapsed after the vehicle is turned off, a temperature of the battery cell, a state of charge (SOC) of the battery cell, a current of the battery cell, or whether a voltage of the battery cell is normally measured (e.g., measured under a pre-determined measurement condition), or any combination thereof.

In the battery diagnostic method according to an embodiment, determining, by the processor, that the abnormal voltage variation is detected in the battery cell, based on that the absolute value of the difference between the first voltage and the third voltage is greater than the first threshold and the absolute value of the difference between the second voltage and the third voltage is greater than the first threshold, ay include determining, by the processor, whether the abnormal voltage variation is detected in the battery cell, based on a time when the condition for determining the failure in the battery cell is satisfied exceeding a predetermined time.

The battery diagnostic method according to an embodiment may further include performing, by the processor, at least one of a restriction on charging the battery cell, a restriction on an output of the battery cell, generation of an alarm associated with the failure in the battery cell, or any combination thereof, based on determining that the failure occurs in the battery cell.

### BRIEF DESCRIPTION OF THE DRAWINGS

The above and other objects, features and advantages of the present disclosure should be more apparent from the following detailed description taken in conjunction with the accompanying drawings, in which:
FIG. 1 is a block diagram illustrating a battery diagnostic apparatus according to an embodiment of the present disclosure;
FIG. 2 is a drawing illustrating an example of a phenomenon in which a momentary voltage variation occurs in a battery cell;
FIG. 3 is a drawing illustrating examples of cases in which an abnormal voltage is detected in a battery cell diagnosed by a battery diagnostic apparatus according to an embodiment of the present disclosure;
FIG. 4 is a drawing for describing an example of updating a reference voltage for determining validity of an abnormal voltage variation in a battery diagnostic apparatus according to an embodiment of the present disclosure;
FIG. 5 is a flowchart for describing a battery diagnostic apparatus or a battery diagnostic method according to an embodiment of the present disclosure;
FIG. 6 is a flowchart for describing a process of detecting an abnormal voltage variation and determining whether there is a failure in a battery cell in a battery diagnostic apparatus according to an embodiment of the present disclosure; and
FIG. 7 is a drawing illustrating a computing system associated with a battery diagnostic apparatus or a battery diagnostic method according to an embodiment of the present disclosure.

### DETAILED DESCRIPTION

Hereinafter, some embodiments of the present disclosure are described in detail with reference to the drawings. In adding the reference numerals to the components of each drawing, it should be noted that the identical component is designated by the identical numerals even when they are displayed on other drawings. Further, in describing embodiments of the present disclosure, a detailed description of well-known features or functions has been ruled out in order not to unnecessarily obscure the gist of the present disclosure.

In describing components of embodiments of the present disclosure, the terms first, second, A, B, (a), (b), and the like may be used herein. These terms are only used to distinguish one component from another component, but do not limit the corresponding components irrespective of the order or priority of the corresponding components. Particularly, the expression "at least one of A, B, or C, or any combination thereof" may include "A", "B", or "C", or "AB" "BC" "AC", or "ABC", which is a combination thereof. Further, each of phrases such as "A or B", "at least one of A and B", "at least one of A or B", "A, B or C", "at least one of A, B and C", "at least one of A, B or C" and "at least one of A, B, or C, or a combination thereof" may include any one or all possible combinations of the items listed together in the corresponding one of the phrases.

In describing the components of embodiments according to the present disclosure, the term "normal" may refer to satisfying associated and/or corresponding condition(s) that may be predetermined, and the term "abnormal" may refer to failing to satisfy associated and/or corresponding condition(s) that may be predetermined. For example, when a voltage variation fails to satisfy a predetermined voltage variation condition, the voltage variation may be determined to be abnormal. In addition, when a voltage fails to satisfy a predetermined voltage condition, the voltage may be determined to be abnormal. Furthermore, when a voltage variation satisfies a predetermined voltage variation condition, the voltage variation may be determined to be normal. In addition, when a voltage satisfies a predetermined voltage condition, the voltage may be determined to be normal.

When a component, processor, controller, device, element, apparatus, or the like of the present disclosure is described as having a purpose or performing an operation, function, or the like, the component, processor, controller, device, element, apparatus, or the like should be considered herein as being "configured to" meet that purpose or to perform that operation or function. Each component, controller, device, element, apparatus, and the like may separately embody or be included with a processor and a memory, such as a non-transitory computer readable media, as part of the apparatus.

Furthermore, unless otherwise defined, all terms including technical and scientific terms used herein have the same meaning as being generally understood by those having ordinary skill in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

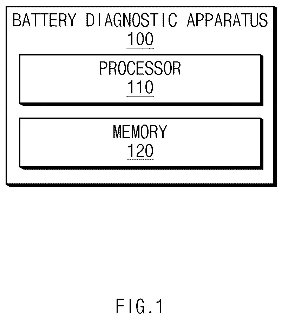

Hereinafter, embodiments of the present disclosure are described in detail with reference to FIGS. 1 - 7.

FIG. 1 is a block diagram illustrating a battery diagnostic apparatus according to an embodiment of the present disclosure.

Referring to FIG. 1, a battery diagnostic apparatus 100 according to an embodiment of the present disclosure may be implemented in a vehicle. In this case, the battery diagnostic apparatus 100 may be integrally configured with control units in the vehicle or may be implemented as a separate device to be connected with the control units of the vehicle by a separate connection means.

According to an embodiment, the battery diagnostic apparatus 100 may include a processor 110 and a memory 120. The configuration of the battery diagnostic apparatus 100 illustrated in FIG. 1 is illustrative and embodiments of the present disclosure are not limited thereto. For example, the battery diagnostic apparatus 100 may further include components which are not illustrated in FIG. 1.

According to an embodiment, the memory 120 may store a command or data. For example, the memory 120 may store one instruction or two or more instructions, when executed by the processor 110, causing the battery diagnostic apparatus 100 to perform various operations.

According to an embodiment, the memory 120 and the processor 110 may be implemented as one chipset and the memory 120 may store various pieces of information associated with the battery diagnostic apparatus 100. For example, the memory 120 may store information about an operation history of the processor 110.

According to an embodiment, the memory 120 may include a non-volatile memory (e.g., a read only memory (ROM)) and a volatile memory (e.g., a random access memory (RAM)). For example, data associated with a voltage of a battery cell, a reference voltage, or the like may be stored in the memory 120.

According to an embodiment, the processor 110 may determine whether a condition for determining a failure in a battery cell is satisfied.

The condition for determining whether there is the failure in the battery cell may include a condition for determining whether the state of the battery cell is a state in which the processor 110 is able to determine a voltage variation failing to satisfy a pre-determined voltage variation condition (hereinafter, also referred to as "an abnormal voltage variation").

According to an embodiment, the condition for determining the failure in the battery cell may include at least one of whether a vehicle including the battery cell is parking, whether the battery cell is being charged, a time elapsed after the vehicle is turned off, a temperature of the battery cell, a state of charge (SOC) of the battery cell, a current of the battery cell, or whether a voltage of the battery cell is normally measured, or any combination thereof. The condition for determining the failure in the battery cell may include a precondition for performing a failure diagnosis of the battery cell.

According to an embodiment, the processor 110 may determine whether the vehicle including the battery cell is parking or whether the battery cell is being charged.

For example, if the vehicle is driving, a current change according to a load of a drive motor or acceleration/deceleration may cause a voltage variation. Thus, the processor 110 may perform a failure diagnosis of the battery cell, if the vehicle is in a parking state or a charging state, to more accurately determine a voltage variation in the battery cell in a situation in which influence of an external load is excluded.

According to an embodiment, the processor 110 may determine whether the temperature of the battery cell is included in a temperature range capable of diagnosing the failure in the battery cell.

For example, if the battery cell is too small or large in temperature (i.e., too low or too high within a temperature range), internal resistance may rapidly change to show an unstable voltage. Thus, if the temperature of the battery cell is in a stable range (e.g., -10°C or more or 50°C or less), the processor 110 may perform the failure diagnosis of the battery cell.

According to an embodiment, the processor 110 may determine whether the SOC of the battery cell is included in an SOC range capable of diagnosing the failure in the battery cell.

For example, if the SOC of the battery cell is extremely small or large, a voltage variation may deviate from a normal operating range. Thus, if the SOC is within a specific range (e.g., 20% or more and 90% or less), the processor 110 may perform the failure diagnosis of the battery cell.

According to an embodiment, the processor 110 may determine whether the current of the battery cell is included in a current range capable of diagnosing the failure in the battery cell.

For example, a temporary voltage drop may occur in a situation in which a charge current or a discharge current rapidly changes. Thus, if a change rate of the current is in a stable range (e.g., if the change rate of the current is less than 1A), the processor 110 may perform the failure diagnosis of the battery cell,

According to an embodiment, the processor 110 may determine whether the time elapsed after the vehicle is turned off is greater than a specific time.

For example, a momentary voltage variation may occur in a load shedding or voltage stabilization process immediately after the vehicle is turned off. Thus, if the time elapsed after the vehicle is turned off is greater than the specific time, the processor 110 may perform the failure diagnosis of the battery cell. Herein, the turn-off of the vehicle may include ignition (IG)-off.

According to an embodiment, the processor 110 may determine whether the voltage of the battery cell is normally measured.

For example, whether the voltage of the battery cell is normally measured may refer to checking whether an error does not occur in a process of sensing the voltage of the battery cell. In other words, there may be a case in which an abnormal voltage value (e.g., a voltage value beyond the pre-determined range) is detected due to a data transfer delay, signal distortion, or abnormality in measurement circuit in a process of communicating with a sensing IC or a battery management system (BMS). The voltage measured in such a case does not actually reflect a state of the battery cell, and it is unable to be used for the failure diagnosis. Thus, if an error does not occur in the process of measuring the voltage of the battery cell, the processor 110 may perform the failure diagnosis of the battery cell.

According to an embodiment, only if all the conditions for determining the failure in the battery cell are satisfied, the processor 110 may perform the failure diagnosis of the battery cell. For another example, although some of the conditions for determining the failure in the battery cell are satisfied, the processor 110 may perform the failure diagnosis of the battery cell. The condition for performing the failure diagnosis of the battery cell may be determined by a user or a system.

According to an embodiment, the processor 110 may identify each of a first voltage of the battery cell at a first time point, a second voltage of the battery cell at a second time point, and a third voltage of the battery cell at a third time point.

According to an embodiment, the first time point may include a current time point.

According to an embodiment, the second time point may refer to a time point before a predetermined time interval from the first time point. For example, if the first time point is "t", the second time point may be "t-1".

According to an embodiment, the third time point may refer to a time point before the predetermined time interval from the second time point. For example, if the second time point is "t-1", the third time point may be "t-2".

The predetermined time interval may be set by the system or the user and may be in units of 1 second, 10 ms, or any other time. Thus, the processor 110 may identify a voltage variation state of the battery cell based on the voltage values measured at the three consecutive time points.

According to an embodiment, the processor 110 may determine that an abnormal voltage variation is detected in the battery cell, based on an absolute value of a difference between the first voltage and the third voltage being greater than a first threshold and an absolute value of a difference between the second voltage and the third voltage being greater than the first threshold.

According to an embodiment, the processor 110 may determine whether the absolute value of the difference between the first voltage and the third voltage is greater than the first threshold. Herein, the first voltage may refer to a voltage measured at the first time point t and the third voltage may refer to a voltage measured at the third time point t-2.

The processor 110 may calculate the absolute value (|V(t) - V(t-2)|) of the difference between the first voltage and the third voltage to quantify how much the voltage at the current time point varies in a short time compared to a voltage before two intervals.

The processor 110 may identify both of abnormal voltage variations including both of a voltage rise and a voltage drop, without limiting a variation in which a voltage rises or a variation in which the voltage drops via the absolute value.

According to an embodiment, the processor 110 may determine whether the absolute value of the difference between the second voltage and the third voltage is greater than the first threshold. Herein, the second voltage may refer to a voltage measured at the second time point t-1 and the third voltage may refer to a voltage measured at the third time point t-2.

The processor 110 may calculate the absolute value (|V(t-1) - V(t-2)|) of the difference between the second voltage and the third voltage to quantitatively check how much the voltage, immediately before the current time point, already varies compared to a voltage before one interval. As a result, the processor 110 may identify consecutive voltage variations.

According to an embodiment, if both the absolute value of the difference between the first voltage and the third voltage and the absolute value of the difference between the second voltage and the third voltage are greater than the first threshold, the processor 110 may determine that an abnormal voltage variation is detected in the battery cell.

According to an embodiment, the first threshold may be set with regard to at least one of sensing resolution, a sampling period, a temperature, an SOC, or a deviation for each cell, or any combination thereof. For example, the first threshold may be set by reflecting resolution of a sensing IC, measurement noise, a normal variation width, a change in internal resistance according to a temperature, or the like.

As a detailed example, the sensing resolution may be used to determine precision of voltage measurement. For example, if a sensing circuit is able to separately measure a voltage in units of 1 mV, it may detect even a minor voltage variation which occurs in the battery cell. On the other hand, because a small voltage variation is able to be ignored in the same situation if resolution decreases to 10 mV or more, sensitivity of detecting the abnormal voltage variation may be lowered.

The sampling period may refer to a time interval for measuring a voltage. If the sampling period is small (e.g., a period of 100 ms), a sudden voltage variation momentarily occurring may be captured without fail. In contrast, if the sampling period is set to be large (e.g., a period of 1 second), there is a possibility that voltage abnormality occurring in a short time is omitted.

The temperature and the state of charge (SOC) are representative physical conditions which have an influence on voltage behavior of the battery cell. Because the smaller the temperature, the more internal resistance increases, a momentary voltage variation may greatly occur even in the same current condition. If the SOC is large, a voltage may sensitively vary even in a small load current.

The deviation for each cell may refer to a difference in voltage characteristic appearing between a plurality of cells in the same battery pack. This may be caused by an error in manufacturing process or a difference in degree of aging of a cell, charging history of the cell, discharging history of the cell, or the like.

For example, according to an embodiment, the first threshold may be set to 1 V. In this case, the processor 110 may determine whether each of the absolute value of the difference between the first voltage and the third voltage and the absolute value of the difference between the second voltage and the third voltage is greater than 1 V.

In detail, it may be assumed that the first voltage measured at the first time point t is 5.0 V, the second voltage measured at the second time point t-1 is 4.8 V, and the third voltage measured at the third time point t-2 is 3.5 V.

In this case, the absolute value |5.0 - 3.5| of the difference between the first voltage and the third voltage is 1.5 V and the absolute value |4.8 - 3.5| of the difference between the second voltage and the third voltage is 1.3 V. Because both of the two values are greater than the first threshold, 1 V, the processor 110 may determine that the abnormal voltage variation is detected in the battery cell.

Thus, the processor 110 may compare the sudden voltage variation occurring during the short duration with the threshold to detect whether the voltage variation is abnormal. As a result, the processor 110 may quickly identify a failure symptom, such as a momentary short or an internal fault of the battery cell.

According to an embodiment, the abnormal voltage variation does not refer to a phenomenon in which a voltage simply rises or drops and may include a phenomenon in which a considerable difference occurs by being compared with a voltage variation capable of occurring in a normal charging and discharging process of the battery cell.

For example, the abnormal voltage variation may include a voltage fluctuation. The voltage fluctuation may refer to a situation in which the voltage of the battery cell does not maintain a stable level while suddenly vibrating up and down in a short time. This may be caused by external interference or internal sensing noise, but may be determined as an abnormal symptom of the battery cell if it repeatedly occurs in the specific battery cell.

Furthermore, the abnormal voltage variation may include a momentary voltage drop by an internal short of the battery cell. For example, if a micro short in the cell occurs, this may show a pattern in which a voltage momentarily and suddenly drops and is recovered again even in a normal SOC.

As such, the processor 110 may identify voltage behavior apparently deviating when compared with a normal voltage variation of the battery cell as the abnormal voltage variation.

According to an embodiment, the processor 110 may determine that a failure occurs in the battery cell, based on the abnormal voltage variation being detected and an absolute value between a difference between the first voltage and a predetermined reference voltage Vnormal being greater than the second threshold.

According to an embodiment, if the abnormal voltage variation is detected in the voltage of the battery cell, the processor 110 may additionally examine validity of the abnormal voltage variation. As described above, the abnormal voltage variation may mean that a voltage abnormally and suddenly varies at consecutive time points.

However, although the absolute value of the difference between the first voltage and the third voltage is greater than the first threshold, it may fail to actually be the abnormal voltage variation.

For example, in a state in which the first threshold is determined as 1 V and the reference voltage Vnormal is determined as 3.5 V, the third voltage may be measured as 2 V and the first voltage may be measured as 3.6 V. In this case, because the absolute value of the difference between the first voltage and the third voltage is 1.6 V and is greater than the first threshold, 1 V, it may be primarily identified as the abnormal voltage variation.

However, because the difference between the first voltage and the reference voltage is merely 0.1 V, the first voltage may be seen as still belonging to a normal voltage range.

Thus, in this case, it may fail to refer to an actual failure although it is identified as the abnormal voltage variation. The processor 110 may compare an absolute value of a difference between the current voltage and the reference voltage to additionally determine the validity of the abnormal voltage variation.

According to an embodiment, if the abnormal voltage variation is detected, the processor 110 may examine whether the absolute value (|V(t) - Vnormal|) of the difference between the current voltage V(t) and the reference voltage Vnormal is greater than the predetermined second threshold to determine the validity of the variation.

According to an embodiment, the processor 110 may determine a voltage immediately before the abnormal voltage variation is detected, among voltages measured in the state in which the condition for determining the failure in the battery cell is satisfied, as the reference voltage.

The reference voltage Vnormal may refer to a voltage value representing a normal operating state of the battery cell. The reference voltage Vnormal may be used as criteria for discriminating whether the voltage variation occurs within the normal range, but is caused by the actual failure.

Furthermore, the reference voltage Vnormal may refer to a normal voltage value in a state in which the voltage is stably maintained without varying to the predetermined first threshold or more, which may be used as a reference value representing a normal cell state before the occurrence of the failure.

For example, if the voltage of the battery cell suddenly drops or rises after a specific time point while being stably maintained as 3.8 V after the charging of the battery cell is completed, the processor 110 may set 3. 8 V measured immediately before the abnormal variation occurs as the reference voltage Vnormal.

According to an embodiment, the second threshold may include a reference value for discriminating whether the difference between the current voltage and the reference voltage is able to be determined as an actual failure. For example, the second threshold may include a value set on the basis of a range capable of being regarded as a normal voltage variation. In general, a small voltage variation may occur in the battery cell depending on a charging and discharging process, a change in ambient temperature, noise of a sensing circuit, or the like. Such a variation may fail to refer to a failure and may be understood as a phenomenon occurring within the normal operating range. Thus, the second threshold may be set with regard to the normal variation range to prevent simple noise or a minor deviation from being incorrectly determined as a failure.

As a detailed example, the current voltage V(t) is measured as 3.2 V in the state in which the reference voltage is set to 3.8 V and the second threshold is 0.5 V, the absolute value of the difference between the current voltage and the reference voltage may be calculated as 0.6 V (|3.8 - 3.2| = 0.6 V). In this case, because the absolute value (0.6 V) of the difference between the current voltage and the reference voltage is greater than the second threshold (0.5V), the processor 110 may determine that the abnormal voltage variation is caused by the actual failure.

In contrast, if the current voltage V(t) is measured as 3.6 V in the state in which the reference voltage is set to 3.8 V, the absolute value |3.8 - 3.6| of the difference between the current voltage and the reference voltage may be calculated as 0.2 V. Because the absolute value (0.2 V) of the difference between the current voltage and the reference voltage is less than or equal to the second threshold (0.5 V), the processor 110 may determine that the abnormal voltage variation is caused by the voltage variation within the normal range. Thus, in this case, it may fail to be finalized (or confirmed) as the actual failure in the battery cell.

As such, the processor 110 may divide a simple temporary variation and the actual failure, via the procedure of detecting the abnormal voltage variation and examining the difference with the reference voltage, and may more reliably detect an actual fault in the battery cell.

According to an embodiment, the processor 110 may finalize or confirm the failure in the battery cell, based on that the number of times it is determined that the failure occurs in the battery cell is greater than a predetermined number of times, within one cycle.

According to an embodiment, the processor 110 may accumulate and manage the number of times it is determined that the failure occurs in the battery cell within the one cycle. If the actual failure in the battery cell is finalized or confirmed using only the result of simply determining that the failure occurs in the specific time point, there is a problem in which incorrect determination by momentary voltage noise or a momentary sensing error is able to be finalized or confirmed as a failure. Thus, the processor 110 may accumulate the number of times it is determined that the failure occurs during one cycle and may finalize or confirm the failure in the battery cell only if the accumulated number of times is greater than the predetermined reference number of times.

Herein, the cycle may include a cycle associated with a battery management system (BMS) of the vehicle including the battery cell.

In detail, the cycle may include a cycle from a time point when the BMS becomes an active state to a time point when the active state switches to an inactive state. The active state of the BMS may include a state in which the BMS is woken up or turned on. The inactive state of the BMS may include a state in which the BMS is shut off.

For another example, the BMS may operate in conjunction with starting of the vehicle. Thus, the cycle may refer to an operating interval of the vehicle including the battery cell. In detail, the cycle may include a cycle from a time point when the vehicle including the battery cell is turned on to a time point when the vehicle is turned off. Such a cycle may be generally defined as a driving cycle, which may indicate an operation unit until the vehicle ends its driving after the vehicle starts to drive.

According to an embodiment, the predetermined number of times may refer to a reference value determined to finalize or confirm the failure in the battery cell. The reference value may indicate a level capable of determining that the number of times it is determined that the failure occurs in the battery cell within the one cycle is not caused by temporary noise or a temporary sensing error and corresponds to the actual failure.

Furthermore, the reference value may fail to be simply based on only whether there is repeated occurrence and may be set by reflecting a behavior characteristic of the battery. For example, a sudden change in cell voltage, which occurs when a short of the battery cell occurs, a voltage deviation between a plurality of battery cells, an abnormal voltage response pattern in a charging process and a discharging process, or the like may be included as a determination element.

Thus, if the number of times it is determined that the failure occurs within the one cycle is greater than a reference value in which the battery behavior characteristic is reflected, the processor 110 may finalize or confirm the failure in the battery cell. As such, the processor 110 may determine whether the number of times it is determined that the failure occurs in the battery cell is greater than the reference value in which the battery behavior characteristic is reflected, thus more increasing reliability of the diagnosis and more accurately identifying an actual failure state of the battery beyond simple noise filtering.

For example, the predetermined number of times may be set to two times, three times, or more, which may vary with a design condition of the BMS, a safety requirement level of the vehicle, or experimental data. Thus, only if the number of times it is determined that the failure occurs within the one cycle is greater than the predetermined number of times, the processor 110 may finalize or confirm the failure in the battery cell, thus increasing the reliability of the diagnosis.

As a detailed example, if determining that the failure occurs three times or more for the same battery cell during one driving cycle, the processor 110 may finalize or confirm it as a substantial failure in the battery cell, rather than a simple voltage variation. In contrast, if the number of times it is determined that the failure occurs within the one cycle is less than or equal to the predetermined number of times, this may be regarded as a temporary abnormality and fail to be finalized or confirmed as the failure.

Thus, the processor 110 may accumulate and verify the number of times a failure is determined in units of a cycle, thus reducing a possibility of error determination based on a single event and more stably and reliably finalizing the failure in the battery cell. As a result, the processor 110 may improve the failure detection accuracy of the BMS and may ensure safety operation of the vehicle.

According to an embodiment, the processor 110 may generate a code associated with the failure in the battery cell, based on the failure in the battery cell being finalized or confirmed. The failure-related code may record the failure in the BMS or an electronic control unit (ECU) of the vehicle and may be subsequently used in a maintenance or diagnostic process.

In detail, the generated failure-related code may include a diagnostic trouble code (DTC) which is a vehicle diagnostic standard. The DTC may be understood as a system for recording various failures occurring in an electronics system of the vehicle in a standardized code format and may be read out by external diagnostic equipment via an on-board diagnostics (OBD) system. For example, if the failure is finalized or confirmed as the abnormal voltage variation is repeatedly detected in a specific battery cell, the processor 110 may generate a DTC including position information and a failure type (or an abnormal voltage) of the cell.

According to an embodiment, the code associated with the failure may be checked via scanner equipment upon vehicle maintenance to immediately identify the necessity of replacing the battery cell, whether performance of the battery cell is degraded, or the necessity of inspecting safety of the battery cell. Furthermore, such a code associated with the failure may be stored in a memory or may be transmitted to an upper control device via a network (e.g., a controller area network (CAN), a local interconnect network (LIN), or the like).

Thus, if the failure in the battery cell is not simply determined and is finalized or confirmed, the processor 110 may generate and manage it as the standardized DTC, thus improving maintenance of the vehicle and may provide the user with quick and accurate diagnostic information.

According to an embodiment, if the state in which the absolute value of the difference between the voltage measured at the time point subsequent to the first time point and the third voltage is greater than the first threshold continues, the processor 110 may fail to increase the number of times it is determined that the failure occurs in the battery cell.

For example, if the state in which the absolute value of the difference between the voltage measured at the time point subsequent to the first time point and the third voltage is greater than the first threshold continues during a certain duration, the processor 110 may fail to see this as occurrence of a new failure and may regard this as belonging to one voltage variation which is previously detected. Thus, the processor 110 may fail to increase the number of times it is determined that the failure occurs in the battery cell.

For example, the abnormal voltage variation capable of leading to the actual failure usually and suddenly occurs in a short interval. Although the state in which it is greater than the threshold subsequently consecutively continues, this may be seen that the abnormal voltage variation is intrinsically an extension of the same voltage variation. Thus, if such all the consecutive states are determined as separate failures, there may occur a problem in which the single voltage variation is incorrectly accumulated as a plurality of failures.

For example, if the third voltage is 3.5 V and the first threshold is 2.0 V and if voltages measured consecutively after the first time point are represented as 6.0 V, 6.0 V, and 6.1 V, differences with the third voltage at the respective time points are 2.5 V, 2.5 V, and 2.6 V, which are greater than the first threshold. However, because all the voltage variations occurring at the three time points are seen as consecutive results of the same pattern, the processor 110 may fail to determine this as a new voltage variation and may group and process this as one voltage variation.

Thus, according to an embodiment of the present disclosure, the processor 110 may regard the consecutive abnormal states as the single voltage variation, thus preventing the same phenomenon from being unnecessarily and repeatedly calculated and controlling the number of times the failure is determined to be identical to the number of voltage variations actually occurring. As a result, the processor 110 may increase reliability of the failure diagnosis and may derive a more accurate result even in the process of finalizing the failure in units of a cycle.

According to an embodiment, the processor 110 may determine the first voltage and the second voltage as abnormal voltages, based on determining that the abnormal voltage variation is detected in the battery cell.

For example, if it is determined that the abnormal voltage variation is detected in the battery cell, the processor 110 may identify voltages involved in the variation as abnormal voltages.

As a detailed example, if the voltage at the first time point t is measured as 6.2 V, the voltage at the second time point t-1 is determined as 6.1 V, the voltage at the third time point t-2 is measured as 3.5 V, and the first threshold is set to 2.0 V, the difference between the first voltage and the third voltage is 2.7 V and the difference between the second voltage and the third voltage is 2.6 V, which are greater than the first threshold. In this case, the processor 110 may identify the first voltage and the second voltage itself as abnormal voltages, as well as determining that the abnormal voltage variation occurs in the battery cell.

According to an embodiment, if an absolute value of a difference between a fourth voltage measured after it is determined that the failure occurs in the battery cell and the third voltage is not greater than the first threshold, the processor 110 may update the reference voltage to the fourth voltage.

According to an embodiment, even after it is determined that the failure occurs in the battery cell, the processor 110 may monitor an additionally measured voltage. A voltage measured at a certain time point after it is determined that the failure occurs may be understood as the fourth voltage.

If the difference between the fourth voltage and the third voltage belongs to the stable range, the processor 110 may update the reference voltage Vnormal to the fourth voltage. In other words, if a voltage matched with the reference voltage is identified again after it is determined that the abnormal voltage variation occurs, the processor 110 may update the identified voltage to the reference voltage.

For example, if the third voltage is 3.5 V and the first threshold is 2.0 V and if the fourth voltage measured after the failure occurs is 3.6 V, the absolute value |3.6 - 3.5| of the difference between the third voltage and the fourth voltage is 0.1 V, which is not greater than the first threshold. In this case, the processor 110 may update the fourth voltage to a new reference voltage Vnormal.

As such, as the processor 110 updates the reference voltage, as normal criteria for reflecting the latest state in the process of comparing the reference voltage with the subsequently measured voltage are applied, the processor 110 may prevent the same failure from being unnecessarily and repeatedly determined. Furthermore, if the state of the battery cell is actually restored to the normal range, the processor 110 may reflect this and may control failure determination from not being excessively accumulated.

According to an embodiment, the processor 110 may determine whether the abnormal voltage variation is detected in the battery cell, based on a time when the condition for determining the failure in the battery cell being satisfied is greater than a predetermined time.

According to an embodiment, the processor 110 may monitor whether the condition for determining the failure in the battery cell continues during a certain time or more. The condition for determining the failure in the battery cell may include at least one of whether the vehicle including the battery cell is parking, whether the battery cell is being charged, a time elapsed after the vehicle is turned off, a temperature of the battery cell, an SOC of the battery cell, a current of the battery cell, or whether a voltage of the battery cell is normally measured, or any combination thereof.

Although the condition is satisfied, if the satisfied state does not sufficiently continue, the processor 110 may fail to perform a diagnosis. This is because an unnecessary false alarm is able to occur due to momentary noise or an external factor, if the condition is satisfied during only a short time and is released again. Thus, only if the failure determination condition is satisfied above the predetermined time, the processor 110 may determine whether the abnormal voltage variation in the battery cell occurs.

Herein, the predetermined time may be set with regard to the behavior characteristic of the battery, rather than a simply randomly defined time. For example, a sudden change in cell voltage, which occurs when a short of the battery cell occurs, a voltage deviation between a plurality of battery cells, a time when a voltage response deviates from the normal range to continue in a charging and discharging process, or the like may be considered.

Thus, the predetermined time may be criteria for discriminating between a temporary voltage variation due to noise or a momentary sensing error and a voltage variation due to an actual battery failure. In other words, only if the time when the condition for determining the failure in the battery cell is satisfied is greater than the predetermined time set based on the behavior characteristic of the battery, the processor 110 may determine whether the abnormal voltage variation is detected in the battery cell, thus increasing reliability and accuracy of the diagnosis.

For example, if the predetermined time is set to 30 seconds and if the condition for determining the failure in the battery cell is continuously maintained during 30 seconds or more, the processor 110 may determine whether the abnormal voltage variation occurs.

As such, only if the state capable of diagnosing the battery cell sufficiently continues, the processor 110 may perform a failure diagnosis, thus preventing unnecessary failure determination according to momentary condition satisfaction and improving reliability and stability of detecting the failure in the battery.

According to an embodiment, the processor 110 may perform at least one of a limitation in or restriction on charging the battery cell, a limitation to or restriction on an output of the battery cell, or generation of an alarm associated with the failure in the battery cell, or any combination thereof, based on determining that the failure occurs in the battery cell.

The processor 110 may limit charging of the battery cell. If a normal charge current is applied to the battery cell in which the failure occurs, risk, such as over-heating, an internal short, or thermal runaway, may occur. Thus, the processor 110 may block a charge current to the battery cell or may limit a magnitude of the charge current, thus ensuring safety.

The processor 110 may limit an output of the battery cell. If the output of the battery cell is maintained as it is, it may be overloaded in a vehicle driving process and damage to the battery cell may be intensified. Thus, the processor 110 may reduce the output of the battery cell determined as the failure or may control the battery cell to separately operate in units of a module or pack in some cases.

The processor 110 may generate an alarm associated with the failure in the battery cell. The alarm may be implemented as a dashboard indication in the vehicle or a warning sound or in the form of being delivered to a controller via a vehicle communication network (e.g., a CAN, a LIN, or the like) and may be recorded as a diagnostic trouble code (DTC) via the on-board diagnostics (OBD) system if necessary. As a result, the user may recognize whether there is a failure in the battery cell and may take appropriate measures.

The protection operations may be performed alone, but may be combined and performed in a form, such as a limitation in or restriction on charging, a limitation to or restriction on an output, and generation of an alarm. For example, the processor 110 may reduce the output of the battery cell and may provide the driver with the alarm, at the same time as limiting the charging of the cell in which the failure is detected, thus simultaneously ensuring safety of the battery and reliability of the vehicle.

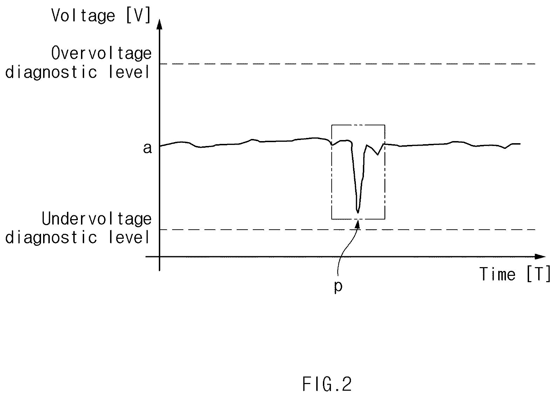

FIG. 2 is a drawing illustrating an example of a phenomenon in which a momentary voltage variation occurs in a battery cell.

Referring to FIG. 2, a voltage of the battery cell is stably maintained near a reference voltage a in a normal state. However, it is checked that an interval p where the voltage suddenly drops occurs, at a specific time point. Such a momentary voltage drop is abnormal behavior occurring between an overvoltage diagnostic level and an undervoltage diagnostic level, which has a feature in which it occurs within a short time and is restored to a normal level again.

Such a momentary voltage variation may cause an important problem in terms of safety control of a high voltage battery. In other words, a voltage fluctuation occurring during a short time may fail to be correctly detected by an existing simple voltage diagnostic logic and makes it difficult to determine whether there is an actual failure. Thus, there is a need for a technology capable of quickly and accurately detecting such a momentary voltage variation in a battery management system (BMS), diagnosing a possibility of a failure in a cell, and ensuring safety of a vehicle.

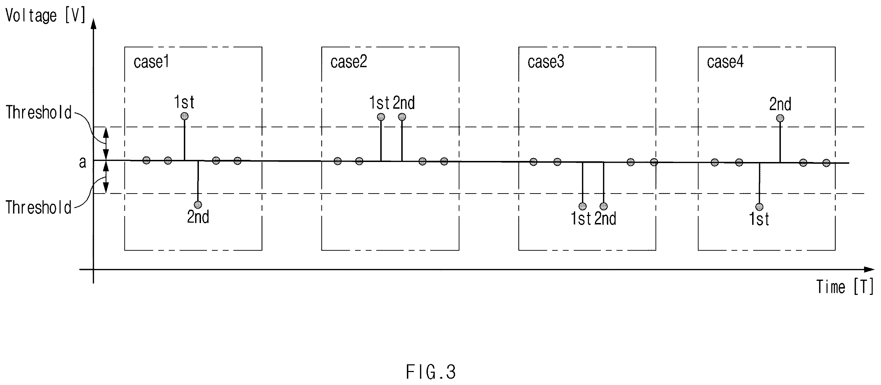

FIG. 3 is a drawing illustrating examples of cases in which an abnormal voltage is detected in a battery cell diagnosed by a battery diagnostic apparatus according to an embodiment of the present disclosure.

Referring to FIG. 3, the horizontal axis indicates voltage (Voltage [V]) and the horizontal axis indicates time (Time [T]). A range of thresholds set respectively above and below the reference voltage a may be displayed, which may refer to an allowable range of a normal voltage variation.

Each point in FIG. 3 indicates a voltage of a battery cell, which is measured over time. If the case in which the voltage of the battery cell is greater than a threshold above and below the reference voltage a is detected two times or more, it may be determined that an abnormal voltage variation occurs.

In Case 1, it is shown that two consecutive abnormal voltage variations are detected in different directions, as a first voltage 1st is greater than a threshold in the direction of being greater than the reference voltage and subsequently, a second voltage 2nd is greater than the threshold in the direction of being less than the reference voltage.

In Case 2, it is shown that abnormal voltage variations are detected two times consecutively, as both of a first voltage 1st and a second voltage 2nd are greater than the threshold in the direction of being greater than the reference voltage.

In Case 3, it is shown that abnormal voltage variations are detected two times consecutively, as both of a first voltage 1st and a second voltage 2nd are greater than the threshold in the direction of being less than the reference voltage.

In Case 4, it is shown that two consecutive abnormal voltage variations are detected in different directions, as a first voltage 1st is greater than the threshold in the direction of being less than the reference voltage and a second voltage 2nd is greater than the threshold in the direction of being greater than the reference voltage.

Thus, as shown in FIG. 3, a battery diagnostic apparatus may effectively detect a pattern in which an abnormal voltage is detected two or more times consecutively. As a result, the battery diagnostic apparatus may more accurately diagnose a failure in a battery cell based on a repeated abnormal voltage variation, rather than single momentary voltage abnormality.

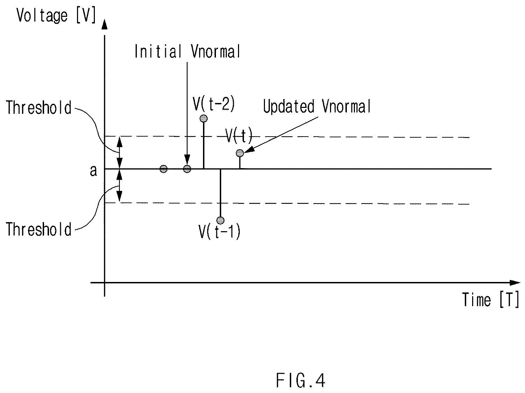

FIG. 4 is a drawing for describing an example of updating a reference voltage for determining validity of an abnormal voltage variation in a battery diagnostic apparatus according to an embodiment of the present disclosure.

FIG. 4 is a graph for describing a process of updating a reference voltage Vnormal for determining validity of an abnormal voltage variation in a battery diagnostic apparatus according to an embodiment of the present disclosure. Referring to FIG. 4, the horizontal axis indicates voltage (Voltage [V]) and the horizontal axis indicates time (Time [T]). A range of thresholds set respectively above and below a stable voltage value a is displayed and a reference voltage Vnormal before being updated is displayed as "Initial Vnormal".

A voltage V(t-2) measured at a time point "t-2" may deviate from a range of thresholds by a momentary voltage rise to be determined as an abnormal voltage variation.

A voltage V(t-1) measured at a time point "t-1" may deviate from a range of thresholds by a momentary voltage drop to be determined as the abnormal voltage variation.

A voltage V(t) measured at a time point "t" may return into the range of thresholds again. In this case, to reflect a state stabilized after an abnormal voltage variation temporarily occurs, a processor 110 may update an existing reference voltage Initial Vnormal to the voltage V(t) measured at the time point "t".

Thus, as shown in FIG. 4, a battery diagnostic apparatus of the present disclosure may dynamically update a reference voltage Vnormal depending on a situation, thus more precisely determining validity of the abnormal voltage variation. This has the effect of more reducing error detection than a scheme which simply and fixedly uses an initial setting value and improving the reliability of diagnosing a failure in a battery cell.

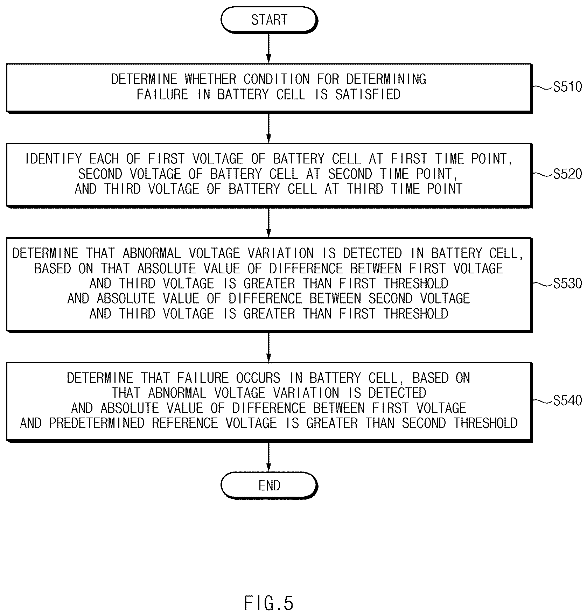

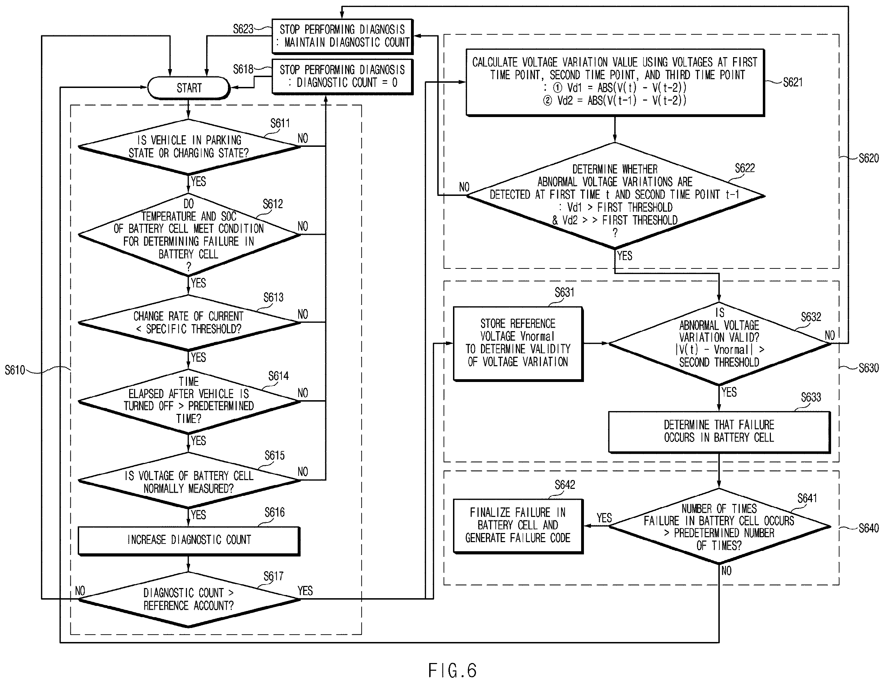

Hereinafter, a description is given in detail of a battery diagnostic apparatus or a battery diagnostic method according to an embodiment of the present disclosure with reference to FIGS. 5 and 6.

Hereinafter, a battery diagnostic apparatus 100 of FIG. 1 performs processes of FIGS. 5 and 6.

FIG. 5 is a flowchart for describing a battery diagnostic apparatus or a battery diagnostic method according to an embodiment of the present disclosure.

According to an embodiment, in S510, the battery diagnostic apparatus may determine whether a condition for determining a failure in a battery cell is satisfied.

According to an embodiment, in S520, the battery diagnostic apparatus may identify or determine each of a first voltage of the battery cell at a first time point, a second voltage of the battery cell at a second time point, and a third voltage of the battery cell at a third time point. Herein, the second time point may refer to a time point before a predetermined time interval from the first time point and the third time point may refer to a time point before the predetermined time interval from the second time point.

According to an embodiment, in S530, the processor 110 may determine that an abnormal voltage variation is detected in the battery cell, based on an absolute value of a difference between the first voltage and the third voltage being greater than a first threshold and an absolute value of a difference between the second voltage and the third voltage being greater than the first threshold.

According to an embodiment, in S540, the processor 110 may determine that a failure occurs in the battery cell, based on that the abnormal voltage variation is detected and an absolute value of a difference between the first voltage and a predetermined reference voltage is greater than a second threshold.

FIG. 6 is a flowchart for describing a process of detecting an abnormal voltage variation and determining whether there is a failure in a battery cell in a battery diagnostic apparatus according to an embodiment of the present disclosure.

Referring to FIG. 6, the battery diagnostic apparatus may perform a process S610 of determining whether a condition for determining a failure in a battery cell is satisfied, a process S620 of determining an abnormal voltage variation, a process S630 of determining validity of the abnormal voltage variation, and a process S640 of finalizing the failure in the battery cell.

According to an embodiment, in S611, the battery diagnostic apparatus may check whether a vehicle is in a parking state or a charging state.

For example, if the vehicle is driving, because a current change according to a load of a drive motor or acceleration/deceleration is able to cause a voltage variation, the battery diagnostic apparatus may perform a failure diagnosis of the battery cell, if the vehicle is in the parking state or the charging state. If the vehicle is not in the parking state or the charging state (NO in S611), the battery diagnostic apparatus may stop performing the diagnosis.

According to an embodiment, in S612, the battery diagnostic apparatus may determine whether a temperature and a state of charge (SOC) of the battery cell meet the condition for determining the failure in the battery cell.

For example, the battery diagnostic apparatus may determine whether the SOC of the battery cell is included in an SOC range capable of diagnosing the failure in the battery cell. In detail, if the SOC is within a specific range (e.g., 20% or more and 90% or less) (YES in S612), the battery diagnostic apparatus may perform a failure diagnosis of the battery cell.

If the temperature and the SOC of the battery cell do not meet the condition for determining the failure in the battery cell (NO in S612), the battery diagnostic apparatus may stop performing the diagnosis.

According to an embodiment, in S613, the battery diagnostic apparatus may determine whether a change rate of a current is less than a specific threshold.

For example, a temporary voltage drop may occur in a situation in which a charge current or a discharge current rapidly changes. Thus, if the change rate of the current is greater than or equal to the threshold (NO in S613), the battery diagnostic apparatus may stop performing the diagnosis.

According to an embodiment, in S614, the battery diagnostic apparatus may check whether a time elapsed after the vehicle is turned off is greater than a predetermined time.

For example, a momentary voltage variation may occur in a load shedding or voltage stabilization process immediately after the vehicle is turned off. Thus, if the time elapsed after the vehicle is turned off is greater than the specific time (YES in S614), the battery diagnostic apparatus may perform a failure diagnosis of the battery cell. Herein, the turn-off of the vehicle may include ignition (IG)-off.

According to an embodiment, in S615, the battery diagnostic apparatus may check whether a voltage of the battery cell is normally measured. Herein, whether the voltage is normally measured may refer to whether there is an error in a voltage sensing process or whether there is a measured value within a normal range.

Conditions for determining the failure in the battery cell are merely one example and may further include additional conditions for determining the failure in the battery cell. Furthermore, the battery diagnostic apparatus may fail to be restricted to an order for determining conditions for determining the failure in the battery cell and may vary the order for determining the conditions or may simultaneously determine the conditions.

According to an embodiment, if the conditions for determining the failure in the battery cell are satisfied, in S616, the battery diagnostic apparatus may increase a diagnostic count. If the diagnostic count is not greater than a predetermined reference account in S617 (NO in S617), the battery diagnostic apparatus may repeat the condition inspection. On the other hand, if the diagnostic count is greater than the reference count (YES in S617), the battery diagnostic apparatus may actually perform a voltage diagnosis of the battery cell.

For example, the battery diagnostic apparatus may use the diagnostic count to check whether the state in which the conditions for determining the failure in the battery cell are satisfied continues during a certain time or more. Herein, the diagnostic count may be understood as a time when the state in which the conditions are satisfied is maintained and may be set such that the diagnostic count is accumulated or increased whenever the condition is met.

According to an embodiment, if any one of the conditions for determining the failure in the battery cell is not satisfied, in S618, the battery diagnostic apparatus may stop performing the diagnosis. In this case, the diagnostic count may be reset to "0".

According to an embodiment, if the diagnostic count is greater than the predetermined reference count (YES in S617), the battery diagnostic apparatus may perform the process S620 of determining the abnormal voltage variation.

According to an embodiment, if the diagnostic count is greater than the predetermined reference count (YES in S617), in S631, the battery diagnostic apparatus may store a reference voltage Vnormal to determine validity of the voltage variation.

According to an embodiment, in S621, the battery diagnostic apparatus may calculate a voltage variation value using voltages at a first time point, a second time point, and a third time point. For example, the processor 110 may calculate an absolute value Vd1 of a difference between a first voltage V(t) at a current time point t and a third voltage V(t-2) at a third time point t-2 and an absolute value Vd2 of a difference between a second voltage V(t-1) at a second time point t-1 and the third voltage V(t-2) at the third time point t-2.

According to an embodiment, in S622, the battery diagnostic apparatus may determine whether the voltage variation values are greater than a first threshold. For example, if both of Vd1 and Vd2 are greater than the first threshold (YES in S622), the battery diagnostic apparatus may determine that an abnormal voltage variation occurs. For example, if both of Vd1 and Vd2 are greater than the first threshold (YES in S622), the battery diagnostic apparatus may determine that abnormal voltage variations occurs two times consecutively.

According to an embodiment, if both of Vd1 and Vd2 are not greater than the first threshold (NO in S622), in S623, the battery diagnostic apparatus may stop performing the diagnosis. In this case, the diagnostic count may be maintained.

According to an embodiment, if it is determined that the abnormal voltage variation occurs, the battery diagnostic apparatus may perform the process S630 of determining the validity of the abnormal voltage variation.

According to an embodiment, in S632, the battery diagnostic apparatus may determine whether an absolute value of a difference between the current voltage V(t) and the reference voltage Vnormal is greater than a second threshold. If the absolute value is greater than the second threshold (YES in S632), it may be determined that the abnormal voltage variation is valid. Thus, in S633, the battery diagnostic apparatus may determine that a failure occurs in the battery cell.

According to an embodiment, if the absolute value of the difference between the current voltage V(t) and the reference voltage Vnormal is not greater than the second threshold (NO in S632), in S623, the battery diagnostic apparatus may stop performing the diagnosis. In this case, the diagnostic count may be maintained.

According to an embodiment, if it is determined that the failure occurs in the battery cell, the battery diagnostic apparatus may perform the process S640 of finalizing the failure in the battery cell.

According to an embodiment, in S641, the battery diagnostic apparatus may determine whether the number of times the failure in the battery cell occurs is greater than a predetermined number of times. For example, if failure determination repeatedly occurs within one driving cycle and the number of times is greater than the predetermined number of times (e.g., three times) (YES in S641), in S642, the battery diagnostic apparatus may finalize or confirm the failure in the battery cell and may generate a failure code (e.g., a DTC).

Thus, an embodiment according to the flowchart of FIG. 6 may examine the condition for determining the failure in the battery cell, may then check whether there are voltage variations at consecutive time points, and may determine validity via comparison with the reference voltage, if the variation is detected, thus dividing a momentary voltage variation and a voltage variation due to an actual failure to reliably determine whether there is a failure in the battery cell.

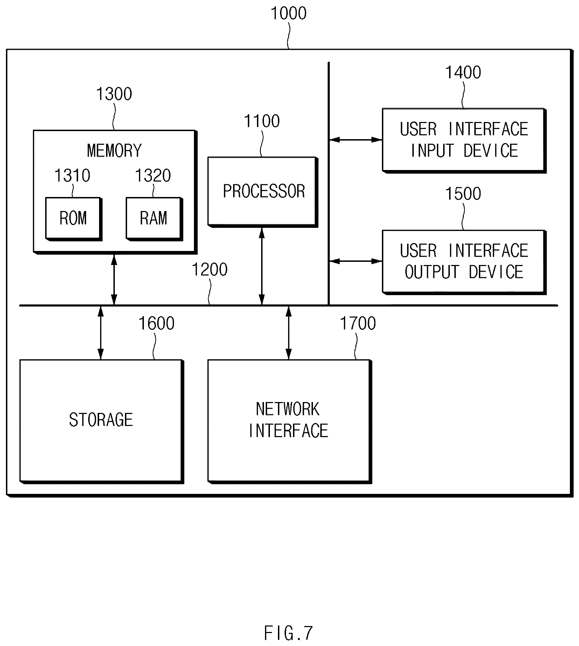

FIG. 7 is a drawing illustrating a computing system associated with a battery diagnostic apparatus or a battery diagnostic method according to an embodiment of the present disclosure.

Referring to FIG. 7, a computing system 1000 may include at least one processor 1100, a memory 1300, a user interface input device 1400, a user interface output device 1500, a storage 1600, and a network interface 1700, which are connected with each other via a bus 1200.

The processor 1100 may be a central processing unit (CPU) or a semiconductor device that processes instructions stored in the memory 1300 and/or the storage 1600. The memory 1300 and the storage 1600 may include various types of volatile or non-volatile storage media. For example, the memory 1300 may include a read only memory (ROM) 1310 and a random access memory (RAM) 1320.

Accordingly, the operations of the method or algorithm described in connection with embodiments disclosed in the specification may be directly implemented with a hardware module, a software module, or a combination of the hardware module and the software module, which is executed by the processor 1100. The software module may reside on a storage medium (i.e., the memory 1300 and/or the storage 1600) such as a RAM, a flash memory, a ROM, an erasable programmable ROM (EPROM), an electrically erasable programmable ROM (EEPROM), a register, a hard disc, a removable disk, and a compact disc ROM (CD-ROM).

The storage medium may be coupled to the processor 1100. The processor 1100 may read out information from the storage medium and may write information in the storage medium. Alternatively, the storage medium may be integrated with the processor 1100. The processor and the storage medium may reside in an application specific integrated circuit (ASIC). The ASIC may reside within a user terminal. In another case, the processor and the storage medium may reside in the user terminal as separate components.

The present technology may detect a momentary voltage variation capable of occurring in a battery cell, thus quickly diagnosing an abnormal state of a cell, which is difficult to be detected using only whether there is a simple over-voltage or low-voltage.

Furthermore, if the case in which a voltage variation in the battery cell is greater than a specific threshold is not merely determined as a single event and is repeated a certain number of times or more, the present technology may finalize or confirm this as a failure, thus reducing misdetection due to temporary noise and improving accuracy of the diagnosed result.

Furthermore, the present technology may include a function of setting a voltage immediately before an abnormal variation in the battery cell voltage is detected as a reference voltage and updating the reference voltage, if a normal state is subsequently checked, thus adaptively responding to a change in battery state in an actual driving and charging environment.

Furthermore, if the failure in the battery cell is finalized or confirmed, the present technology may generate a DTC associated with this or may perform subsequent control, such as a limitation in or restriction on charging, a limitation to or restriction on output, or generation of an alarm, thus quickly notifying a vehicle driver of an abnormal situation and ensuring vehicle safety.

In addition, various effects ascertained directly or indirectly through the present disclosure may be provided.

Hereinabove, although the present disclosure has been described with reference to embodiments and the accompanying drawings, the present disclosure is not limited thereto, but may be variously modified and altered by those having ordinary skill in the art to which the present disclosure pertains without departing from the spirit and scope of the present disclosure claimed in the following claims.

Therefore, embodiments of the present disclosure are not intended to limit the technical spirit of the present disclosure, but provided only for the illustrative purpose. The scope of the present disclosure should be construed on the basis of the accompanying claims, and all the technical ideas within the scope equivalent to the claims should be included in the scope of the present disclosure.

## Claims

1. A battery diagnostic apparatus, comprising:
a memory storing program instructions; and
a processor, by executing the program instructions, configured to
determine whether a condition for determining a failure in a battery cell is satisfied,
determine a first voltage of the battery cell at a first time point, a second voltage of the battery cell at a second time point, and a third voltage of the battery cell at a third time point,
determine that a voltage variation failing to satisfy a pre-determined voltage variation condition is detected in the battery cell, based on an absolute value of a difference between the first voltage and the third voltage being greater than a first threshold and an absolute value of a difference between the second voltage and the third voltage being greater than the first threshold, and
determine that the failure occurs in the battery cell, based on that the voltage variation failing to satisfy the pre-determined voltage variation condition is detected and an absolute value of a difference between the first voltage and a reference voltage is greater than a second threshold,
wherein the second time point is a time point before a predetermined time interval from the first time point, and
wherein the third time point is a time point before the predetermined time interval from the second time point.

2. The battery diagnostic apparatus of claim 1, wherein the processor is further configured to:
confirm the failure in the battery cell, based on that a number of times it is determined that the failure occurs in the battery cell is greater than a predetermined number of times, within a cycle associated with a battery management system of a vehicle including the battery cell.

3. The battery diagnostic apparatus of claim 2, wherein the cycle includes a cycle from a time point at which the battery management system becomes an active state to a time point at which the active state switches to an inactive state.

4. The battery diagnostic apparatus of anyone of claims 1-3, wherein the processor is further configured to:
maintain a number of times it is determined that the failure occurs in the battery cell, based on a state in which an absolute value of a difference between a voltage measured a time point subsequent to the first time point and the third voltage is greater than the first threshold being maintained.

5. The battery diagnostic apparatus of anyone of claims 1-4, wherein the processor is further configured to:
determine the first voltage and the second voltage as voltages failing to satisfy a pre-determined voltage condition, based on determining that the voltage variation failing to satisfy the pre-determined voltage variation condition is detected in the battery cell.

6. The battery diagnostic apparatus of anyone of claims 1-5, wherein the processor is further configured to:
determine a voltage before the voltage variation failing to satisfy the pre-determined voltage variation condition is detected, among voltages measured in a state in which the condition for determining the failure in the battery cell is satisfied, as the reference voltage.

7. The battery diagnostic apparatus of anyone of claims 1-6, wherein the processor is further configured to:
update the reference voltage to a fourth voltage measured after it is determined that the failure occurs in the battery cell, based on an absolute value of a difference between the fourth voltage and the third voltage being smaller than or equal to the first threshold.

8. The battery diagnostic apparatus of anyone of claims 1-7, wherein the condition for determining the failure in the battery cell is associated with at least one of whether a vehicle including the battery cell is parking, whether the battery cell is being charged, a time elapsed after the vehicle is turned off, a temperature of the battery cell, a state of charge (SOC) of the battery cell, a current of the battery cell, whether a voltage of the battery cell is measured under a pre-determined measurement condition, or any combination thereof.

9. The battery diagnostic apparatus of anyone of claims 1-8, wherein the processor is configured to:
determine whether the voltage variation failing to satisfy the pre-determined voltage variation condition is detected in the battery cell, based on a time when the condition for determining the failure in the battery cell is satisfied exceeding a predetermined time.

10. The battery diagnostic apparatus of anyone of claims 1-9, wherein the processor is configured to:
perform at least one of a restriction on charging the battery cell, a restriction on an output of the battery cell, generation of an alarm associated with the failure in the battery cell, or any combination thereof, based on determining that the failure occurs in the battery cell.

11. A battery diagnostic method, comprising:
determining, by a processor, whether a condition for determining a failure in a battery cell is satisfied;
determining, by the processor, a first voltage of the battery cell at a first time point, a second voltage of the battery cell at a second time point, and a third voltage of the battery cell at a third time point;
determining, by the processor, that a voltage variation failing to satisfy a pre-determined voltage variation condition is detected in the battery cell, based on an absolute value of a difference between the first voltage and the third voltage being greater than a first threshold and an absolute value of a difference between the second voltage and the third voltage being greater than the first threshold; and
determining, by the processor, that the failure occurs in the battery cell, based on that the voltage variation failing to satisfy the pre-determined voltage variation condition is detected and an absolute value of a difference between the first voltage and a reference voltage is greater than a second threshold,
wherein the second time point is a time point before a predetermined time interval from the first time point, and
wherein the third time point is a time point before the predetermined time interval from the second time point.

12. The battery diagnostic method of claim 11, further comprising:
confirming, by the processor, the failure in the battery cell, based on that a number of times it is determined that the failure occurs in the battery cell is greater than a predetermined number of times, within a cycle associated with a battery management system of a vehicle including the battery cell.

13. The battery diagnostic method of claim 11 or 12, further comprising:
maintaining a number of times it is determined that the failure occurs in the battery cell, based on a state in which an absolute value of a difference between a voltage measured a time point subsequent to the first time point and the third voltage is greater than the first threshold being maintained.

14. The battery diagnostic method of anyone of claims 11-13, wherein determining, by the processor, that the voltage variation failing to satisfy the pre-determined voltage variation condition is detected in the battery cell, based on that the absolute value of the difference between the first voltage and the third voltage is greater than the first threshold and the absolute value of the difference between the second voltage and the third voltage is greater than the first threshold, includes:
determining, by the processor, the first voltage and the second voltage as voltages failing to satisfy a pre-determined voltage condition, based on determining that the voltage variation failing to satisfy the pre-determined voltage variation condition is detected in the battery cell.

15. The battery diagnostic method of anyone of claims 11-14, wherein determining, by the processor, that the failure occurs in the battery cell, based on that the voltage variation failing to satisfy the pre-determined voltage variation condition is detected and the absolute value of the difference between the first voltage and the reference voltage is greater than the second threshold, includes:
determining, by the processor, a voltage before the voltage variation failing to satisfy the pre-determined voltage variation condition is detected, among voltages measured in a state in which the condition for determining the failure in the battery cell is satisfied, as the reference voltage.
